# EUROPEAN PATENT SPECIFICATION

(11) **EP 0 407 620 B1**
(45) Date of publication and mention of the grant of the patent: **21.09.1994**
(21) Application number: 90902682.5
(22) Date of filing: 02.02.1990
(51) Int. Cl.: H01L 23/427, F28D 15/02

(54) **ELECTRIC INSULATION TYPE HEAT PIPE COOLER**
HEIZLEITUNGSKÜHLVORRICHTUNG VOM TYP MIT ELEKTRISCHER ISOLIERUNG
REFROIDISSEUR DE CALODUC DE TYPE A ISOLATION ELECTRIQUE

(30) Priority: 02.02.1989 JP 24699/89
(43) Date of publication of application: 16.01.1991
(73) Proprietor: THE FURUKAWA ELECTRIC CO., LTD., Tokyo 100 (JP)
(72) Inventor: KIMURA, Yuichi, Yokohama-shi Kanagawa-ken 241 (JP); SOTANI, Junji, Yokohama-shi Kanagawa-ken 245 (JP)
(74) Representative: Boeters, Hans Dietrich, Dr.
(86) International application number: JP9000128
(87) International publication number: WO9008935

(56) References cited:
- JP-A- 5 912 288
- US-A- 4 761 970
- PATENT ABSTRACTS OF JAPAN vol. 5, no. 189 (M-99) 28 November 1981 & JP-A-56 108 098
- PATENT ABSTRACTS OF JAPAN vol. 7, no. 171 (C-178) 28 July 1983 & JP-A-58 079 078
- IBM TECHNICAL DISCLOSURE BULLETIN. vol. 20, no. 7, December 1977, New York US HWANG: 'HEAT EXCHANGER FOR VAPOR CONDENSATION BY DROPWISE TECHNIQUE

## Description

### Technical Field

The present invention relates to an improved electrically insulated heat pipe cooler used for cooling, for example, semiconductor devices or electronic equipment.

### Background Art

To cool heat-generating part of semiconductor devices or electronic equipment, a heat pipe type cooler is used. In this heat pipe cooling type cooler, one end of a heat pipe is inserted into a hole drilled in a block (heat sink) for collecting or dispersing heat, the inserted part is allowed to serve as an evaporating section, the other end of the heat pipe is provided with fins to serve as a heat dissipating section, and the heat of the block section is dissipated through the heat dissipating section. Such a heat pipe is described, for example, in Japanese Patent Application (OPI) Nos. 293654/1987 and 293655/1987.

As a feature of that heat pipe, it can be mentioned that the heat flux conversion can be effected by changing the ratio between the lengths of the heat transfer pipes of the evaporating section and the condensing section.

On the other hand, in recent years, techniques for processing thyristors or the like have been improved and the scale of semiconductor devices has been made large, so that they can be used, for example, for railway vehicles. When large-scale semiconductor devices are used. for railway vehicles, since there is a possibility that they come in contact with a person because of the places where they are installed, it is desired that the evaporating section and the condensing section are electrically insulated in view of the safety, so that one having an electrically insulating section between the evaporating section and the condensing section is now used. Such heat pipes are illustrated for example in Fig. 4. In Fig. 4, a block (6) good in thermal conductivity and made of copper or the like is formed with one or more tubular holes (7), evaporating sections (21) at one end of heat pipes each comprising a tubular body are inserted into the holes (7), the other ends of the heat pipes are provided with a number of fins (9) to form condensing sections (22) that are tubular, and electrical insulators (23) made, for example, of alumina ceramic are located between the evaporating sections and the condensing sections and are secured with sealers (24), (24′). An electrically insulating working fluid (8) is confined in each of said heat pipes thereby forming an electrically insulated heat pipe cooler. Although, in the above prior embodiment, the individual heat pipes are inserted into the respective holes formed in the block, it is needless to say that the block (6) itself may serve as evaporating sections of the heat pipes.

Generally, the heat transfer properties of heat pipes exhibit good performance when they are used near the boiling point of the working fluid under normal pressures. As a working fluid, Furon (a chlorofluorocarbon, hereinafter referred to as CFC) is used in many cases and, for example, in the range of -30 to 100°C that is a temperature range usually used, CFC-11 (CCℓ₃F), CFC-12 (CCℓ₂F₂), HCFC-21 (CHCℓ₂F), HCFC-22 (CHCℓF₂), or CFC-113 (CCℓ₂F.CCℓF₂) is used.

### Disclosure of the Invention

Although CFC is widely used as a working fluid in the normal temperature region in heat pipe coolers as described above, CFC has problems mentioned below.
(a) CFC gas discharged into the atmosphere diffuses into the stratosphere and destroys the ozone layer of the stratosphere, which presents a serious environmental problem. Therefore, restriction is about to be imposed on the amount of the production of CFC and the amount of its use.
(b) When CFC is used at a temperature of 100°C or over, it decomposes and changes in quality thereby deteriorating the performance of heat pipes, so that a heat pipe whose stability is good for a long period of time and whose life is long cannot be obtained.

Further, with respect to working fluids, in addition to the boiling points, the compatibility of the working fluid with the material of heat pipe containers has to be taken into consideration. That is, in some cases, a chemical reaction takes place between a working fluid and a container wall in the heat pipe, so that the container inner surface is oxidized or corroded or the working fluid causes denaturation to deteriorate the performance of the heat pipe, which means the compatibility of the working fluid with the material of the heat pipe container is poor.

The present invention has been made with the above points taken into consideration and the object of the present invention is to provide an electrically insulated heat pipe cooler that exhibits high performance stably near 100°C without a fear of causing harmful influence on the environment.

That is, the present invention provides an electrically insulated heat pipe cooler wherein a tubular body comprises an evaporating section and a condensing section connected through an electrical insulator, said evaporating section is a hole of a tubular body provided, for example, in a thermally conductive block or a tubular body inserted in said hole, and the condensing section is a tubular body provided with fins, characterized in that as working fluid a carbon fluoride type working fluid that contains a carbon fluoride compound having a boiling point corresponding to the working temperature in an amount of 95 % or over and a carbon fluoride compound having a boiling point lower than that of the former carbon fluoride compound in an amount of 1 % or below is used.

In the present invention, the term "working temperature" refers to the temperature at which the working fluid that is the major component evaporates (condenses) under atmospheric pressure. There is no particular limit to the working temperature of the heat pipe cooler of the present invention, but the working temperature is generally -40 to 140°C and preferably -30 to 120°C.

The term "carbon fluoride compound" refers to a compound obtained by causing substitution onto a hydrocarbon by fluorine which does not substantially include a chlorine-substituted one. Herein, by the term "does not substantially include" it is meant to allow a case wherein a trace amount of a chlorine-substituted compound remains in the product in the manufacture of a carbon fluoride compound wherein a chloride is once produced and then is converted to the fluoride. In this specification and claims, the percentages indicating the composition of the carbon fluoride type working fluid represent percentages by area obtained by gas chromatography.

### Brief Description of Drawings

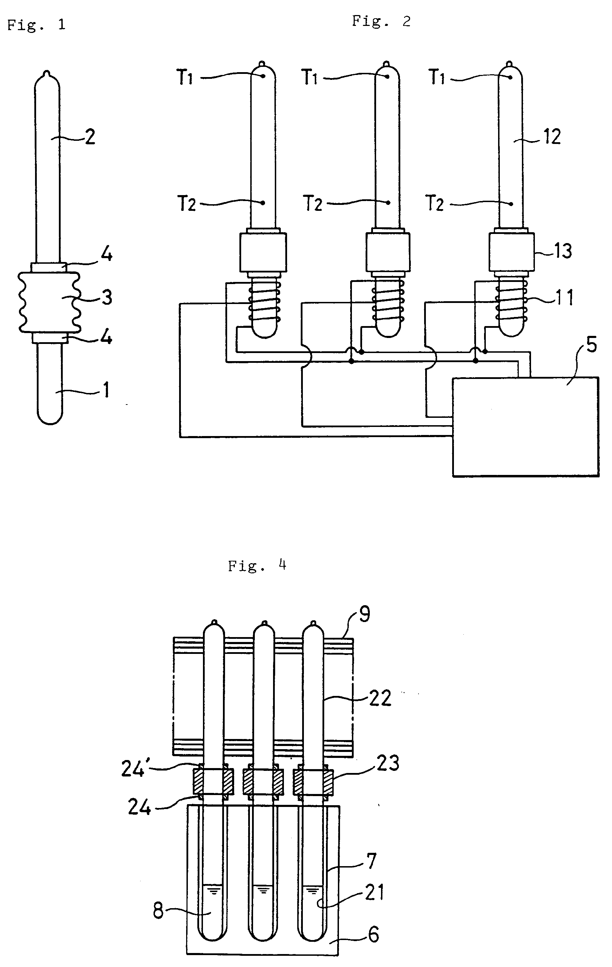

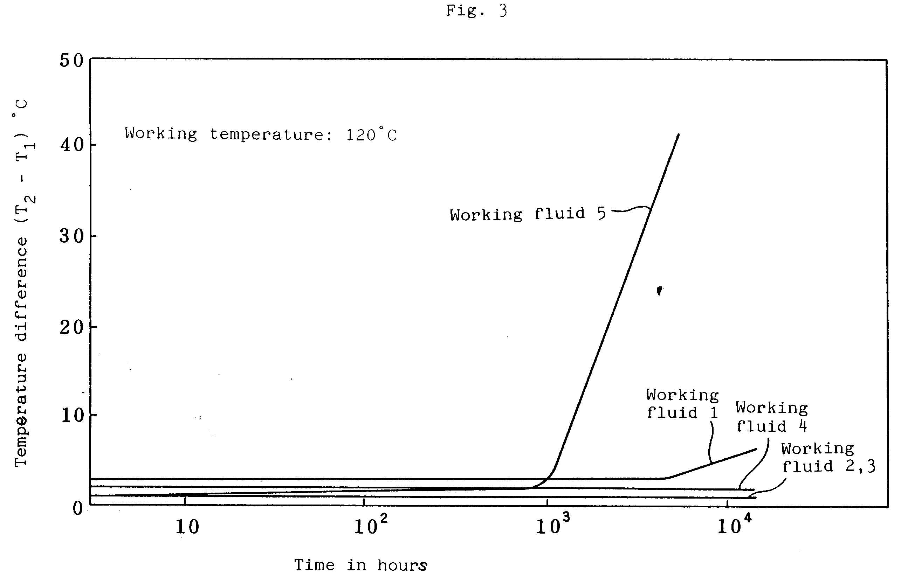

Fig. 1 is a front view of an embodiment of an electrically insulated heat pipe according to the present invention; Fig. 2 is an explanatory view of a compatibility test apparatus of heat pipe working fluids; Fig. 3 is a graph showing the results of a compatibility test; and Fig. 4 is a cross-sectional view of an electrically insulated heat pipe cooler.

### Best Mode for Carrying Out the Invention

Now, an embodiment of the present invention will be described below.

Fig. 1 shows an electrically insulated heat pipe of an embodiment according to the present invention and the electrically insulated heat pipe comprises an evaporating section (1) and a condensing section (2) that are made up of copper tubes (for example having an inner diameter of 16 mm) and are connected through a cylindrical electrical insulator (3) of an alumina ceramic. The electrical insulator (3) has an enough creeping distance so as to secure electrical insulating performance. The connection of the alumina ceramic of the electrical insulator (3) to the copper tubes of the evaporating section (1) and the condensing section (2) was done by metallizing the opposite end surfaces of the electrical insulator (3), plating the metallized surfaces with Ni, brazing sealers (4) of an Ni-Fe alloy plated with Ni and the electrical insulator (3) by using silver, and then brazing the sealers (4) to the evaporating section (1) and the condensing section (2). A working fluid containing C₆F₁₄ in an amount of 90 % (hereinafter referred to as working fluid 1) or a working fluid containing C₆F₁₄ in an amount of 95 % and a component whose boiling point is lower than that of C₆F₁₄ (such as C₄F₉H or C₅F₁₂) in an amount of 0 % (hereinafter referred to as working fluid 2) or in an amount of 1 % (hereinafter referred to as working fluid 3) or in an amount of 2 % (hereinafter referred to as working fluid 4) was confined in the thus formed heat pipe container to make a heat pipe, and the heat pipe cooler was run for a long period of time to test the stability thereof. If the compatibility of the working fluid for heat pipes with the material of the container is poor, the stability is poor. For comparison, a heat pipe wherein CFC-113 (CCℓ₂F.CCℓF₂, hereinafter referred to as working fluid 5) was confined as conventional chlorofluorocarbon was made. The measurement of the components after the running was carried out by using a gas chromatograph and a mass spectrometer.

Fig. 2 shows a test apparatus for testing compatibility of the working fluids for heat pipes used in the above test with the material of the container. The temperature of an evaporating section (11) of the heat pipe was maintained at a prescribed temperature by a temperature controller (5), the temperature difference (T₂ - T₁) between the temperature on the side of the evaporating section (11) and the temperature on the side of a condensing section (12) was measured with time, and when the temperature difference remained the same for a long period of time, the compatibility of the working fluid was judged good. The temperature of the evaporating section (11), that is, the working temperature was set 120°C, and the temperature difference between the central part of the heat pipe and the condensing section end was measured. The results are shown in Fig. 3. According to the results, in the heat pipe using the working fluid 5 (CFC-113), the temperature difference (T₂ - T₁) starts to increase after about 1,000 hours whereas in the heat pipes using the working fluids 2 and 3, an increase in the temperature difference (T₂ - T₁) is not almost recognized even after about 10,000 hours, and it has become apparent that they can be used adequately in a copper type material.

It became apparent that in the working fluid 1 wherein the content of the major component indicating the boiling point of the working temperature was low, the temperature difference was inclined to increase before 10,000 hours, and in the working fluid 4 wherein the low-boiling component was 2 %, the temperature difference occurred from the initial state. On the other hand, when the working temperature was 90°C, any temperature difference was not observed in any of the working fluids after 10,000 hours.

From the above results, it was found that the working fluids 2 and 3 could be used in a temperature range wider than that of the working fluid 5. Since the heat performance of the working fluids 2 and 3 was approximately equal to that of the working fluid 5 and the working fluids 2 and 3 are not harmful to the environment, by using the working fluids 2 and 3 as working fluid for heat pipes, an excellent electrically insulated heat pipe cooler can be obtained.

When a fluid having a composition made up of C₆F₁₄, C₅F₁₂, C₅F₁₁Cℓ, C₆F₁₃H, and C₇F₁₆ in amounts of 98.7 %, 0.4 %, 0.2 %, 0.1 %, and 0.6 % respectively was confined as a working fluid, and a test similar to the above was carried out, good results similar to those of the working fluids 2 and 3 could be obtained.

In the above embodiments, a copper heat pipe container having an insulator mainly made of an alumina ceramic was used, but in the cases of an aluminum heat pipe container and a stainless steel heat pipe container, excellent compatibility is obtained similarly.

The fluorinated compound having the boiling point of the working temperature used in the present invention is preferably a perfluorocarbon, which may be used alone or may additionally contain other perfluorocarbon having a different carbon number or a less fluorinated fluorocarbon that will be present therein in practice when it is produced if it falls within the range of the present invention, which is a feature of the present invention.

In the present invention, the carbon fluoride compound having the boiling point of the working temperature accounts for 95 % or over, preferably 96 % or over, and more preferably 98 % or over of the carbon fluoride type working fluid.

A plurality of electrically insulated heat pipes constituted as above are inserted into holes (7) of a block (6) of copper as shown in Fig. 4, a solder is loaded between the evaporating sections (21) and the block (6) in order to lower thermal resistance, the condensing sections (22) are provided with fines (9), and the evaporating sections (1) and the condensing sections (22) are connected through electrical insulators (23), so that an insulated heat pipe cooler is constituted. Although, in the embodiment, the heat pipes are inserted into the block to constitute an electrically insulated heat pipe cooler, the holes formed in the block may be used themselves for the tubular bodies of the evaporating sections.

As described above, according to the present invention, by using a carbon fluoride type working fluid wherein the proportion of the major component of the working fluid is 95 % or over and the proportion of the component having a boiling point below the boiling point of the major component is 1 % or below, the present invention has an excellent effect which can provide an electrically insulated heat pipe cooler that can be run continuously for a long period of time stably even at a working temperature of 100°C or over and whose working fluid is free from a fear of causing an environmental problem and is good in compatibility with the parts.

In other words, according to the present invention, it is not needed to use CFC, and by using a medium purified as described above, an electrically insulated heat pipe cooler wherein the conversion between the two phases of a gas and a fluid is easy, and the working fluid is thermally and chemically stable, is not-toxic and does not adversely influence the environment can be obtained.

### Industrial Applicability

As described above, the electrically insulated heat pipe cooler according to the present invention is high in safety because of the fact that the evaporating-section and the condensing section are insulated electrically, is high in stability, can be run continuously, and is useful for cooling, for example, large-scale semiconductor devices and electronic equipment for railway vehicles.

## Claims

1. An electrically insulated heat pipe cooler comprising an evaporating section (21) and a condensing section (22) connected through an electrical insulator (23), the condensing section (22) being a tubular body provided with fins (9), a working fluid (8) in said heat pipe coder, characterized in that as working fluid there is used a carbon fluoride type working fluid that contains a first carbon fluoride compound having a boiling point corresponding to the working temperature in an amount of 95 % or over and a second carbon fluoride compound having a lower boiling point than that of said first carbon fluoride compound in an amount of 1 % or below, wherein the percentages indicating the composition of the carbon fluoride type working fluid represent percentages by area obtained by gas chromatography.

2. The heat pipe cooler as claimed in claim 1, wherein said evaporating section is a tubular hole (7) provided in a thermally conductive block or a tubular body inserted in said hole.

3. The heat pipe cooler as claimed in claim 1, wherein said tubular body is made of aluminum or stainless steel.

4. The heat pipe cooler as claimed in claim 1, wherein the working temperature is -30 to 120°C.

5. The heat pipe cooler as claimed in claim 1, wherein said first carbon fluoride compound having the boiling point of the working temperature is a perfluorocarbon.

6. The heat pipe cooler as claimed in claim 1, wherein the tubular body is made of copper.

## Patentansprüche

1. Elektrisch isolierte Kühlvorrichtung für Heizungsrohre, mit einem Verdampfungsabschnitt (21) und einem Kondensierungsabschnitt (22), die über einen elektrischen Isolator (23) miteinander verbunden sind, wobei der Kondensierungsabschnitt ein rohrartiger Körper ist, der mit Lamellen (9) versehen ist, einer in der Kühlvorrichtung für Heizungsrohre vorgesehenen Arbeitsflüssigkeit(en) (8), dadurch gekennzeichnet, daß als Arbeitsflüssigkeit eine Fluor-Kohlenstoff-Verbindung verwendet wird, die eine erste Fluor-Kohlenstoff-Zusammensetzung in einer Menge von 95% oder mehr aufweist, deren Siedepunkt bei der Arbeitstemperatur liegt, und eine zweite Fluor-Kohlenstoff-Zusammensetzung in einer Menge von 1% oder weniger aufweist, deren Siedepunkt unter demjenigen der ersten Fluor-Kohlenstoff-Zusammensetzung liegt, wobei die auf die Zusammensetzung der Fluor-Kohlenstoff-Verbindung der Arbeitsflüssigkeit hinweisenden Prozentsätze Flächenprozente einer mittels Gas-Chromatographie erhaltenen Fläche sind.

2. Kühlvorrichtung für Heizungsrohre nach Anspruch 1, dadurch gekennzeichnet, daß der Verdampfungsabschnitt ein rohrartiges Loch (7) ist, das in einem thermisch leitenden Block oder einem rohrartigen Körper vorgesehen ist, der in das Loch eingebracht ist.

3. Kühlvorrichtung für Heizungsrohre nach Anspruch 1, dadurch gekennzeichnet, daß der rohrartige Körper aus Aluminium oder rostfreiem Stahl hergestellt ist.

4. Kühlvorrichtung für Heizungsrohre nach Anspruch 1, dadurch gekennzeichnet, daß die Arbeitstemperatur zwischen -30 und 120° liegt.

5. Kühlvorrichtung für Heizungsrohre nach Anspruch 1, dadurch gekennzeichnet, daß die erste Fluor-Kohlenstoff-Zusammensetzung mit einem Siedepunkt bei der Arbeitstemperatur ein Perfluor-Kohlenstoff ist.

6. Kühlvorrichtung für Heizungsrohre nach Anspruch 1, dadurch gekennzeichnet, daß der rohrartige Körper aus Kupfer gefertigt ist.

## Revendications

1. Refroidisseur à caloduc isolé électriquement comportant un tronçon d'évaporation (21) et un tronçon de condensation (22) reliés par l'intermédiaire d'un isolant électrique (23), le tronçon de condensation (22) étant un corps tubulaire muni d'ailettes (9), un fluide de service (8) situé dans ledit refroidisseur à caloduc, caractérisé en ce qu'en tant que fluide de service, on utilise un fluide de service du type fluorure de carbone qui contient un premier composé de fluorure de carbone, ayant un point d'ébullition correspondant à la température de service, dans une proportion de 95% ou plus et un second composé de fluorure de carbone ayant un point d'ébullition plus faible que celui dudit premier composé de fluorure de carbone, dans une proportion de 1% ou inférieure, dans lequel les pourcentages indiquant la composition des fluides de service du type fluorure de carbone représentent les pourcentages par zone obtenus par chromatographie en phase gazeuse.

2. Refroidisseur à caloduc selon la revendication 1, dans lequel ledit tronçon d'évaporation est un trou tubulaire (7) agencé dans un bloc thermiquement conducteur ou est un corps tubulaire inséré dans ledit trou.

3. Refroidisseur à caloduc selon la revendication 1, dans lequel ledit corps tubulaire est constitué d'aluminium ou d'acier inoxydable.

4. Refroidisseur à caloduc selon la revendication 1, dans lequel la température de service est comprise entre -30 et 120°C.

5. Refroidisseur à caloduc selon la revendication 1, dans lequel ledit premier composé de fluorure de carbone, ayant le point d'ébullition de la température de service, est un carbure perfluoré.

6. Refroidisseur à caloduc selon la revendication 1, dans lequel le corps tubulaire est constitué de cuivre.
